# EUROPEAN PATENT SPECIFICATION

(11) **EP 0 342 594 B1**
(45) Date of publication and mention of the grant of the patent: **10.08.1994**
(21) Application number: 89108761.1
(22) Date of filing: 16.05.1989
(51) Int. Cl.: H01L 31/02, H01L 23/48

(54) **An optical semiconductor device**
Optisches Halbleiterbauelement
Dispositif optique à semiconducteur

(30) Priority: 16.05.1988 JP 118946/88; 16.05.1988 JP 118947/88
(43) Date of publication of application: 23.11.1989
(73) Proprietor: SUMITOMO ELECTRIC INDUSTRIES, LTD., Osaka-shi, Osaka 541 (JP)
(72) Inventor: Sekiguchi, Takeshi c/o Yokohama Works of Sumitomo, Yokohama-shi Kanagawa (JP); Shiga, Nobuo c/o Yokohama Works of Sumitomo, Yokohama-shi Kanagawa (JP); Aga, Keigo c/o Yokohama Works of Sumitomo, Yokohama-shi Kanagawa (JP)
(74) Representative: Kahler, Kurt, Dipl.-Ing.

(56) References cited:
- DE-B- 2 546 189
- IBM TECHNICAL DISCLOSURE BULLETIN, vol. 29, no. 4, September 1986, page 1637, Armonk, New Jersey, US ; "Selective etchant for tin-lead composition determination".
- PATENT ABSTRACTS OF JAPAN, vol. 10, no. 1 (E-371)(2058), 7 January 1986 ; & JP-A-60 165 749

## Description

### Background of the Invention

### (Field of the Invention)

The present invention relates to an optical semiconductor device used as a transmitting or receiving optical module in an optical communication system.

### (Related Background Art)

As a transmitting optical module of this type, a light-emitting element such as a semiconductor laser (LD) or a light-emitting diode (LED) for converting an electrical signal into a light signal and sending the light signal onto an optical fiber and a drive integrated circuit (IC) for driving the light-emitting element are mounted on a single insulating substrate as a hybrid IC, and this substrate is housed in a package. Similarly, as a receiving optical module, a hybrid IC substrate mounting a light-receiving element such as a photodiode (PD) or phototransistor for converting a light signal received from an optical fiber into an electrical signal and an amplifying IC for amplifying the output signal from the light-receiving element are housed in a package.

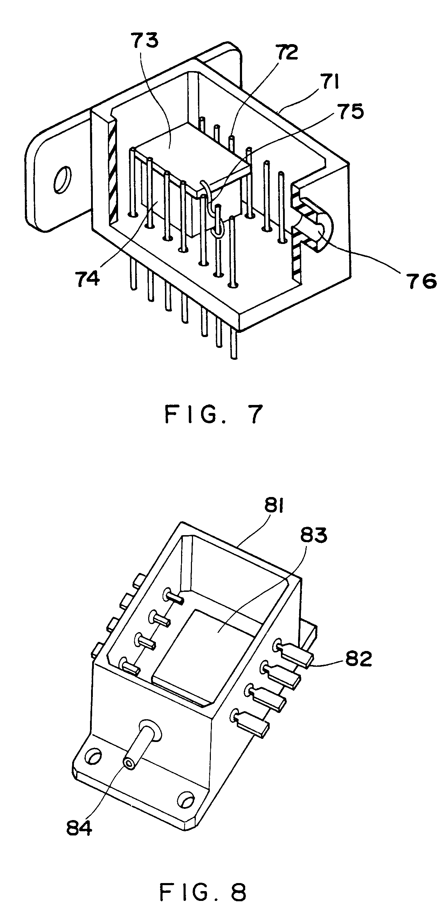

Each package has a structure having a through hole into which the optical fiber is inserted, and terminal pins used for an electrical input/output operation. The packages are classified into two types according to alignment state of the terminal pins. One of them is, as shown in Fig. 7, a DIP (Dual In-line Package) type in which terminal pins 72 extend from a bottom surface of a package 71 to be substantially perpendicular to the major surface of a hybrid IC substrate 73. The other one is, as shown in Fig. 8, a butterfly type in which terminal pins 82 extend from side surfaces of a package 81 to be substantially parallel to the major surface of a hybrid IC substrate 83. Note that reference numerals 76 and 84 in Figs. 7 and 8 denote optical fiber insertion ports, respectively.

In the above structure, the hybrid IC substrate 73 or 83 mounting the optical semiconductor device and the IC is assembled inside the alignment of the terminal pins 72 or 82. More specifically, the hybrid IC substrate 73 or 83 is fixed on a substrate base 74 mounted on the bottom surface of the package, and the terminal pins 72 or 82 are aligned to surround the substrate assembly.

For this reason, the package size is increased both in the DIP type and the butterfly type in which the terminal pins extend laterally.

Electrical connections between the hybrid IC substrate 73 or 83 and the terminal pins 72 or 82 are formed through wires 75 or the like. Since a distance between the substrate and each terminal is large, an inductance is increased, and as a result electrical characteristics are impaired.

Furthermore, since the hybrid IC substrate 73 or 83 is fixed in the package 71 or 81 quite independently of the terminal pin group, it is difficult to align the substrate with the terminal pins.

### Summary of the Invention

It is a main object of the present invention to provide an optical semiconductor device which has a small package in size, has good electrical characteristics, and can be very easily achieved alignment of a hybrid IC substrate.

Accordingly the present invention provides an optical semiconductor device in which holes are formed in the major surface of a hybrid IC insulating substrate, and head portions of terminal pins extending from a bottom surface of a DIP type package are inserted in and fixed to these holes as featured in claim 1.

According to another aspect, the present invention provides an optical semiconductor device in which holes having tapered inner surfaces are formed in the major surface of a hybrid IC insulating substrate, and the terminal pins extending from a bottom surface of a package are connected and fixed to the substrate while head portions of the terminal pins are inserted in these holes.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only. The present invention concerns also a method of manufacturing the terminal pin insertion holes.

### Brief Description of the Drawings

Fig. 1 is a partially cutaway perspective view showing an embodiment of an optical semiconductor device according to the present invention;
Fig. 2 is a perspective view of a hybrid IC substrate of this embodiment;
Fig. 3 is a sectional view showing a connecting state of the hybrid IC substrate and each terminal pins of package;
Fig. 4 is a sectional view showing a connecting state of a hybrid IC substrate formed with holes each having a tapered inner surface and a corresponding terminal pin of a package;
Figs. 5 and 6 are respectively sectional views showing modifications of the hole having the tapered inner surface; and
Figs. 7 and 8 are perspective views showing related background arts of the present invention.

### Description of the Preferred Embodiment

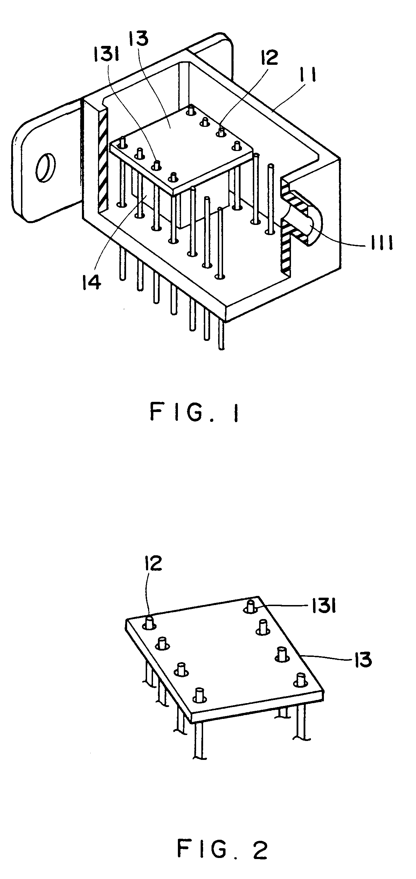

Fig. 1 shows a structure of an embodiment of the present invention while removing an upper surface and some side surface portions so that the interior of a package 11 can be seen well. A portion denoted by reference numeral 111 is a cylindrical optical fiber insertion port although only a half portion is illustrated.

The package 11 basically has a DIP structure comprising terminal pins arranged essentially perpendicular to the major surface of a hybrid IC substrate 13. Unlike the structure shown in Fig. 7, arrays of terminal pins 12 are located inside the hybrid IC substrate 13.

The hybrid IC substrate 13 comprises various elements including an optical semiconductor element (not shown) mounted on a ceramic insulating substrate. Holes 131 extending through upper and lower major surfaces are formed in the peripheral portion of the substrate 13, as shown in Fig. 2, and head portions of the terminal pins 12 are inserted therein.

The hybrid IC substrate 13 with the above structure can be relatively easily fabricated in such a manner that the holes 131 are punched in a ceramic substrate still in a soft green sheet state and the substrate is then sintered in the manufacture of the ceramic substrate. Alternatively, holes may be formed in the sintered ceramic substrate by, e.g., boring process in use of a laser machine tool.

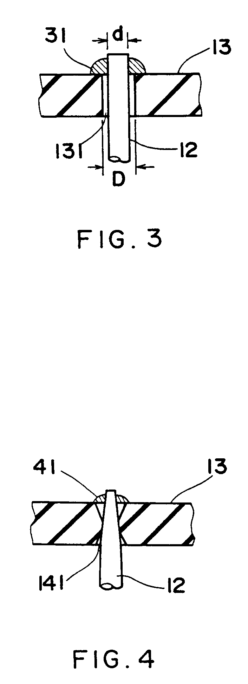

Each terminal pin 12 extends through the bottom surface of the package 11. The head portion of the terminal pin 12 is inserted in the corresponding hole of the hybrid IC substrate 13, and in this state, is directly fixed thereto by a solder 31, as shown in Fig. 3. Thus, the hybrid IC substrate 13 and the terminal pins 12 are mechanically fixed to each other, and a circuit on the hybrid IC substrate 13 and the terminal pins 12 are electrically connected to each other.

In this manner, since the arrays of the terminal pins 12 pass inside the hybrid IC substrate 13, a necessary space in the package can be reduced as compared to the structure in Fig. 7 in which the arrays of the terminals are arranged outside the substrate

Unlike the structure in Fig. 7 in which the hybrid IC substrate 73 and the terminal pins 72 are separated from each other, and are connected through lead wires, since the substrate and the terminal pins can be directly soldered to each other, generation of an unnecessary inductance can be minimized.

Furthermore, since the head portions of the terminal pins 12 are inserted in the holes 131 of the hybrid IC substrate 13, the substrate 13 can be automatically aligned with the terminal pins.

In this embodiment, the terminal pin 12 has an outer diameter d = 0.45 mm, while each hole 131 of the hybrid IC substrate 13 has an inner diameter D = 0.7 mm. However, the present invention is not limited to this. For example, a difference between d and D can be so large as to allow easy insertion of the terminal pin 12 in the hole 131 and can be so small as to allow easy soldering therebetween such that the outer surface of ther terminal pin 12 is not excessively separate from the inner surface of the hole 131.

In place of the solder 31, another connecting means, e.g. a conductive adhesive may be used to directly fix the terminal pins 12 and the hybrid IC substrate 13.

In the above embodiment, the holes 131 having cylindrical inner surfaces are formed in the hybrid IC substrate 13. However, the hybrid IC substrate 13 may have holes 141 having tapered inner surfaces, as shown in Fig. 4.

The holes 141 can be relatively easily formed in a sintered ceramic substrate by, e.g., a laser machine tool using a YAG laser.

The tapered inner surface of each hole 141 serves as a guide when the corresponding terminal pin 12 is inserted, thus facilitating insertion of the terminal pins 12. In the illustrative embodiment, since the head portion of each terminal pin 12 is also tapered toward the distal end, insertion can be further facilitated.

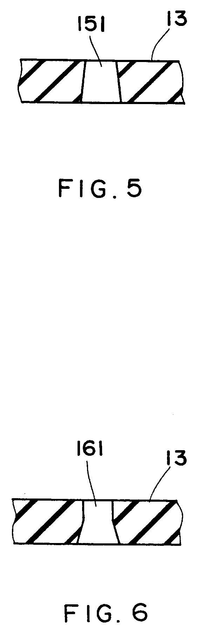

The hole having the tapered inner surface is not limited to one illustrated in Fig. 4. For example, a hole 151 shown in Fig. 5 or a hole 161 shown in Fig. 6 may be employed.

When a metal layer (conductive material layer) of, e.g., gold or aluminum having good conductivity may be formed on the tapered inner surface of each hole 141, 151, or 161 like a through hole in a printed circuit board, electrical contact between the terminal pins 12 and a circuit on the hybrid IC substrate 13 can be improved. Such a metal layer can be formed simultaneously with formation of a metal wiring layer on the major surface of the hybrid IC substrate 13.

## Claims

1. An optical semiconductor device comprising an insulating substrate (13) on which a hybrid integrated circuit including an optical semiconductor element is formed and which is housed in a package (11) having terminal pins (12) extending from the bottom of the package substantially perpendicularly to a major surface of said insulating substrate, said terminal pins being connected and fixed to said insulating substrate, the head portions of said terminal pins being inserted in corresponding terminal pin insertion holes (131; 141; 151; 161) formed in the major surface of said insulating substrate.

2. An optical semiconductor device according to claim 1, wherein each of the terminal pin insertion holes (141; 151; 161) has a tapered inner surface.

3. An optical semiconductor device according to any one of claims 1 to 2, wherein a conductive material layer is formed on the inner surface of each of the terminal pin insertion holes (131; 141; 151; 161).

4. An optical semiconductor device according to any one of claims 1 to 3, wherein a distal end of each of said terminal pins (12) is tapered.

5. Method of manufacturing an optical semiconductor device according to claim 1, wherein the terminal pin insertion holes (131; 141; 151; 161) are formed in said insulating substrate (13) in a soft green sheet state by punching process, and the punched substrate is then sintered.

6. Method of manufacturing an optical semiconductor device according to any one of claims 1 to 4, wherein the terminal pin insertion holes (131; 141; 151; 161) are formed in said insulating substrate (13) by laser machining after said substrate is sintered.

## Patentansprüche

1. Ein optisches Halbleiterbauelement, das ein isolierendes Substrat (13) aufweist, auf dem eine ein optisches Halbleiterelement einschließende Hybridschaltung ausgebildet ist und das in einem Gehäuse (11) mit Anschlußstiften (12) untergebracht ist, die sich vom Boden des Gehäuses im wesentlichen senkrecht zu einer Hauptfläche des isolierenden Substrats erstrecken, wobei die Anschlußstifte mit dem isolierenden Substrat verbunden und an diesem befestigt sind, und wobei die Kopfteile der Anschlußstifte in entsprechende, in der Hauptfläche des isolierenden Substrats ausgebildete Anschlußstift-Einsetzlöcher (131; 141; 151; 161) eingesetzt sind.

2. Ein optisches Halbleiterbauelement nach Anspruch 1, wobei jedes der Anschlußstift-Einsetzlöcher (141; 151; 161) eine verjüngte Innenfläche aufweist.

3. Ein optisches Halbleiterbauelement nach einem der Ansprüche 1 bis 2, wobei eine leitfähige Materialschicht auf der Innenfläche jedes der Anschlußstift-Einsetzlöcher (131; 141; 151; 161) ausgebildet ist.

4. Ein optisches Halbleiterbauelement nach einem der Ansprüche 1 bis 3, wobei ein distales Ende von jedem der Anschlußstifte (12) verjüngt ist.

5. Verfahren zum Herstellen eines optischen Halbleiterbauelements nach Anspruch 1, bei dem die Anschlußstift-Einsetzlöcher (131; 141; 151; 161) mittels eines Stanzverfahrens in dem isolierenden Substrat (13), das sich in einem weichen, ungesinterten Zustand befindet, ausgebildet werden und das gestanzte Substrat dann gesintert wird.

6. Verfahren zum Herstellen eines optischen Halbleiterbauelements nach einem der Ansprüche 1 bis 4, bei dem die Anschlußstift-Einsetzlöcher (131; 141; 151; 161) nach dem Sintern des Substrats in dem isolierenden Substrat (13) mittels Laserbearbeitung ausgebildet werden.

## Revendications

1. Un dispositif optique à semi-conducteur comprenant un substrat isolant (13) sur lequel on a monté un circuit intégré hybride incluant un élément semi-conducteur optique, lequel substrat est logé dans un boîtier (11) et lequel comporte des broches (12) dépassant du fond du boîtier (11) de façon pratiquement perpendiculaire à l'une des grandes surfaces dudit boîtier, lesdites broches étant connectées et fixées audit substrat isolant, le haut desdites broches étant inséré dans les trous d'insertion pour broches correspondants (131; 141; 151; 161), percés dans la surface dudit substrat isolant.

2. Un dispositif optique à semi-conducteur selon la revendication 1, dans lequel chacun des trous d'insertion pour broches (141; 151; 161) présente une surface interne conique.

3. Un dispositif optique à semi-conducteur selon l'une quelconque des revendications 1 à 2, dans lequel chacun des trous d'insertion pour broches (131; 141; 151; 161) présente une surface interne recouverte d'une couche de matériau conducteur.

4. Un dispositif optique à semi-conducteur selon l'une quelconque des revendications 1 à 3, dans lequel chacune desdites broches (12) présente une extrémité conique.

5. Une méthode pour la fabrication d'un dispositif optique à semi-conducteur selon la revendication 1, dans laquelle on réalise les trous d'insertion pour broches (131; 141; 151; 161) dans ledit substrat isolant (13) par un procédé de poinçonnage de la feuille de substrat à l'état encore malléable, puis par le frittage du substrat poinçonné.

6. Une méthode pour la fabrication d'un dispositif optique à semi-conducteur selon l'une quelconque des revendications 1 à 4, dans laquelle on réalise les trous d'insertion pour broches (131; 141; 151; 161) dans ledit substrat isolant (13) par un procédé de perforation par laser après que le frittage dudit substrat ait été réalisé.
